# EUROPEAN PATENT SPECIFICATION

(11) **EP 2 396 828 B1**
(45) Date of publication and mention of the grant of the patent: **06.11.2013**
(21) Application number: 10705429.8
(22) Date of filing: 16.02.2010
(51) Int. Cl.: F24J 2/04, F24J 2/26, F24J 2/50, F24J 2/00, F24J 2/46, F24J 2/52, H01L 31/058, H01L 31/052

(54) **SOLAR ENERGY COLLECTION APPARATUS**
SOLARENERGIE-SAMMELVORRICHTUNG
APPAREIL DE COLLECTE D'ÉNERGIE SOLAIRE

(30) Priority: 16.02.2009 ZA 200901066
(43) Date of publication of application: 21.12.2011
(73) Proprietor: Van Niekerk, Daniel Gabriel, 1459 Boksburg (ZA); Davis, Bevan John, 1401 Germiston (ZA)
(72) Inventor: VAN NIEKERK, Daniel Gabriel, 1459 Boksburg (ZA)
(74) Representative: Haley, Stephen
(86) International application number: PCT/IB2010/050681
(87) International publication number: WO 2010/092559

(56) References cited:
- EP-A2- 0 905 795
- US-A1- 2008 011 289

## Description

### BACKGROUND TO THE INVENTION

THIS invention relates to a solar energy collection apparatus.

Photovoltaic (PV) cells are widely used to convert solar energy to electricity. However it is well known that such cells are relatively inefficient to the extent that in a typical case, a PV panel may convert only about 15% of incident solar energy to electricity leaving the balance to be dissipated as heat. It is furthermore well known that the efficiency of a PV cell decreases with increasing temperature. It has, for example, been said that for every degree Celsius rise in temperature the electrical power produced by a PV cell decreases by 0.5%.

For these reasons, considerable research has been conducted into the dissipation of the heat generated by PV cells. Currently, the research is directed primarily towards improving heat removal from PV cells using natural convection. In these solutions, air gaps are created beneath and possibly around the PV panel such that natural convection of air through the gap(s) removes heat generated by the cells. A distinct and recognised problem with such arrangements is however the fact that the air is heated up during its passage through the gap(s) so that air initially entering the gap is cooler than that leaving the gap. This in turn means that less heat is removed from more elevated cells which accordingly run at lower electricity generating efficiency.

Another problem with known PV cell configurations is the fact that the cells are extremely thin and brittle. Where the cells are made up into large modules or panels, as is typically the case, breakage of a single cell or small region of the module or panel will generally render the entire module or panel inoperative. In these situations it is generally necessary to replace the entire module or panel, typically at substantial cost.

The above disadvantage of known PV module and panel configurations is particularly serious in cases where the modules or panels are mounted on a roof. In such situations, the modules and panels are readily prone to breakage as a result of sharp impacts from, for example, large hailstones or acts of vandalism in which vandals throw hard objects such as stones or bricks onto roof-mounted units, or as a result of workers or other persons walking or falling on the modules or panels.

The specification of US2008/011289 A1 describes a solar energy collection apparatus which can be mounted as a separate unit on an existing roof or other structure. The apparatus includes rigid support components of thermally conductive material which can be connected to one another. Solar cells are mounted to the support components in heat-transmitting relationship with the support components. Thermally conductive conduits are connected to the components and convey water to remove heat from the cells. US 2008/011289 describes an solar energy collection apparatus as defined in the preamble of independent claim 1.

One object of the present invention is to provide a solar energy collection system, based on PV cells or solar energy absorbers, with improved heat removal characteristics. A further object of the invention is to provide a solar energy collection apparatus in which the PV cells or solar energy absorbers are supported with sufficient rigidity to avoid or at least reduce the possibility of cell breakage but in which partial replacement of a solar panel can be achieved in a convenient manner should breakage take place.

### SUMMARY OF THE INVENTION

The above objects are met by a solar energy collection apparatus as set forth in claim 1 and preferred features are set forth in the dependent claims.

The objective of heat removal from the PV cells or solar energy absorbers is achieved by the water-conveying conduits. It will be understood that the water which is conveyed in the conduits and is thermally heated by the PV cells or solar energy absorbers can be used in other applications requiring heated water. Examples of such applications are geysers and swimming pools where an elevated water temperature is desired.

Preferably the rigid support structure comprises a plurality of elongate, rigid, extruded components of thermally conductive material which are connected releasably to one another, each component defining at least one elongate recess in which an elongate row of PV cells or solar energy absorbers is/are fixed in heat transmitting relationship with the material of the component. The releasable interconnection of components is conveniently achieved by way of releasable component clips.

Typically, extruded components of the rigid support structure include integral, transverse formations along long edges of the components, the formations of adjacent components lying alongside one another and the system including component clips which engage the formations releasably to connect the components to one another.

In the preferred arrangement, each cover has side edges which are connected releasably to the first formations by the component clips. There may be seals between the side edges of the cover and the transverse formations and between the side edges of the cover and the component clips.

Typically also, the components of the rigid support structure include further integral, transversely projecting formations extending longitudinally and defining undercut channels and the cover includes integral, transverse ribs which are received in sliding manner in the channels.

The components of the rigid support structure may also include integral, transversely oriented receptacles in which the conduits are received, the system including thermally conductive conduit clips which are clipped into the receptacles to anchor the conduits in the receptacles. Preferably each receptacle and associated clip, in combination, define a cavity which is complemental in shape to the external surface of a conduit. Typically the conduit has a round cylindrical outer surface and the receptacle and associated clip in combination define a cavity with an internal surface which is complementally round cylindrical in cross-section. For improved thermal transmission there may be a thermally conductive elastomer between the external surface of the conduit and the internal surface of the cavity.

The objective of supporting the PV cells or solar energy absorbers with sufficient rigidity to avoid or at least reduce the possibility of cell or absorber breakage but allowing partial replacement is achieved by the rigidity of the extruded components, each carrying some of the cells, and the fact that the components are connected to one another in a releasable manner. Accordingly if one or only a few cells or absorbers should be damaged or broken it is possible to remove and replace only the affected component(s). The rigidity of the extruded components is attributable in the main to the various transverse formations which provide the components with an increased resistance to bending.

In the preferred embodiments using PV cells, each recess has a width corresponding to that of a single PV cell, i.e. each recess accommodates a single row of PV cells. Thermal transmission is improved by providing, in each recess, a thermally conductive elastomer between the bases of the PV cells and the base of the recess.

The apparatus may include connectors which are connectable to battens of the roof support structure and are connected releasably to the transverse formations. Conveniently the connectors are connected releasably to the first formations by the action of the component clips.

The apparatus may comprise extruded edge members which are connected releasably to components at opposite sides of the rigid support structure by the component clips and to which can be attached flashing members for overlapping neighbouring regions of the roof cladding structure on opposite sides of the apparatus. It may also comprise end members connected to ends of the components in order to provide the solar energy collection apparatus with closed ends.

### BRIEF DESCRIPTION OF THE DRAWINGS

The invention will now be described in more detail, by way of example only, with reference to the accompanying drawings in which:
- **Figure 1**: shows a cross-sectional view of a solar energy collection apparatus according to this invention;
- **Figures 2 to 4**: show cross-sectional views of extruded components seen in Figure 1;
- **Figure 5**: an elevation view of and end member;
- **Figure 6**: shows a cross-sectional view of an edge member;
- **Figure 7**: shows a cross-sectional view of the component clip seen in Figure 1;
- **Figure 8**: shows a cross-sectional view of the conduit clip seen in Figure 1; and
- **Figure 9**: shows a cross-sectional view of the connector seen in Figure 1.

### DESCRIPTION OF THE ILLUSTRATED EMBODIMENT

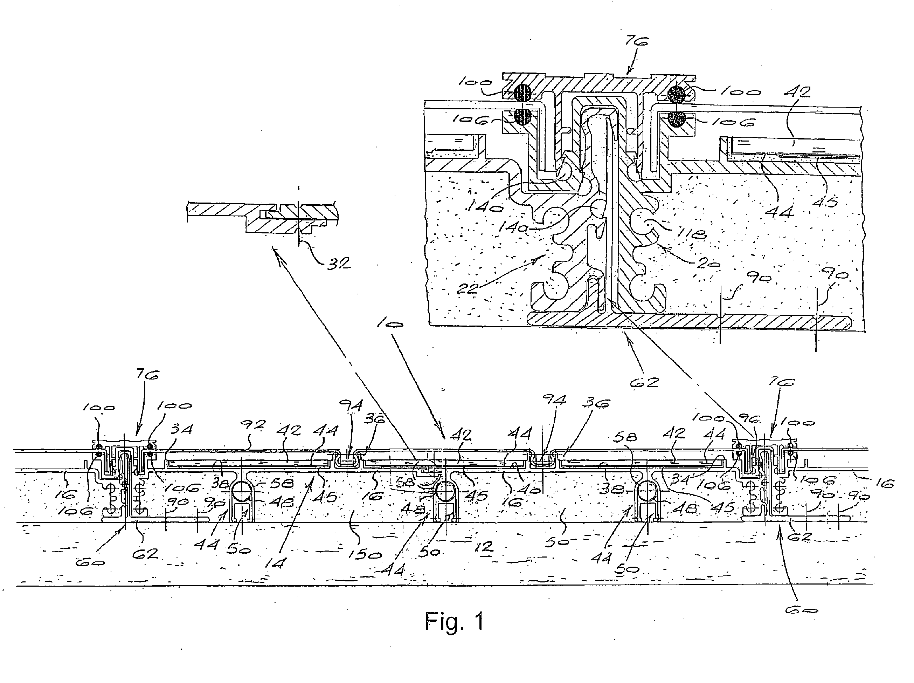

The solar energy collection apparatus 10 seen in Figure 1 is designed to form part of a roof cladding structure, i.e. the apparatus will actually form part of the roof cladding, typically between neighbouring regions of the roof cladding which may, for example, consist of tiles, metal sheets or the like.

The numeral 12 in Figure 1 indicates a batten or purlin, typically of timber, which spans transversely over rafters (not shown) in a conventional pitched roof structure.

The system 10 includes a rigid support structure, indicated generally by the numeral 14, which includes elongate, extruded components 16 of a material with a high degree of thermal conductivity, in this case, aluminium. The components 16 are elongate in a direction into the plane of the paper in Figure 1.

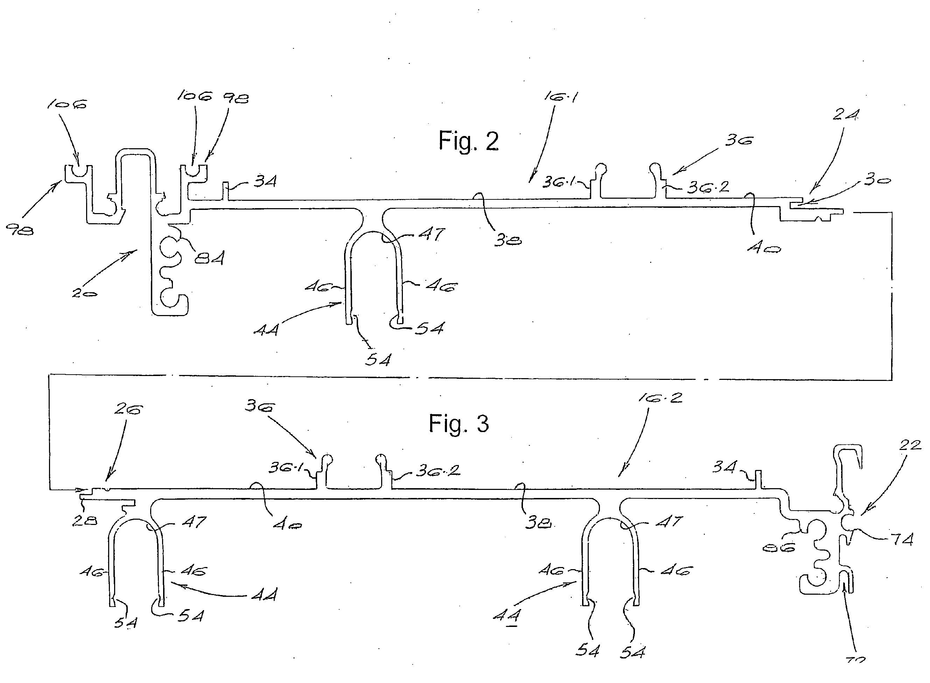

In the illustrated embodiment, each extruded component 16 is made up of two extruded sub-components 16.1 and 16.2 which are illustrated at a larger scale in Figures 2 and 3 respectively. The sub-component 16.1 includes an integral formation 20 which is transverse to the length of the extrusion, which has the illustrated cross-sectional shape and which runs for the length of the sub-component along one side edge. The sub-component 16.2 also includes an integral formation 22 which is transverse to the length of the extrusion, which has the illustrated cross-sectional shape and which runs for the length of the sub-component along a side edge. At their opposite side edges the sub-components 16.1 and 16.2 include edge formations 24, 26 which are mated with another as seen in the enlargement in Figure 1, with a tongue 28 of the edge formation 26 locating in a groove 30 of the other edge formation. At this junction, the sub-components are fixed rigidly to one another by means of suitable fasteners indicated diagrammatically by the numeral 32 in Figure 1.

Although in this embodiment, each component 16 is composed of two sub-components it will be understood that in other embodiments, each component may be formed as a one-piece, integral extrusion or of more than two interconnected sub-components.

The component 16 includes upstanding ribs 34 as well as transversely projecting formations 36 each composed of upstanding elements 36.1, 36.2 which define an undercut channel between them. The ribs and formatioins 36 extend longitudinally for the length of the component 16. Between each rib 34 and a formation 36 there is a recess 38 extending for the length of the component. A further recess 40 is defined between the formations 36.

The recesses 38, 40 accommodate PV cells 42. In practice, each recess 38, 40 has a width slightly greater than that of a single cell 42, typically about 100mm. In each recess there is a single row of cells 42, the row extending for the length of the component 16. The cells 42, which typically have a backing 44 of Tedlar® or other suitable thermally conductive film, are fixed in the recess by a thermally conductive adhesive 45, in this case a thermally conductive elastomeric adhesive such that marketed as Dow Corning 3-6655. In practice, the cells are embedded in the adhesive in the recess and so are in an intimate, thermally transmitting relationship with the thermally conductive material of the component 16, i.e. aluminium in this case.

The electrical connections between the adjacent cells are not shown in the drawings, but may be taken as conventional.

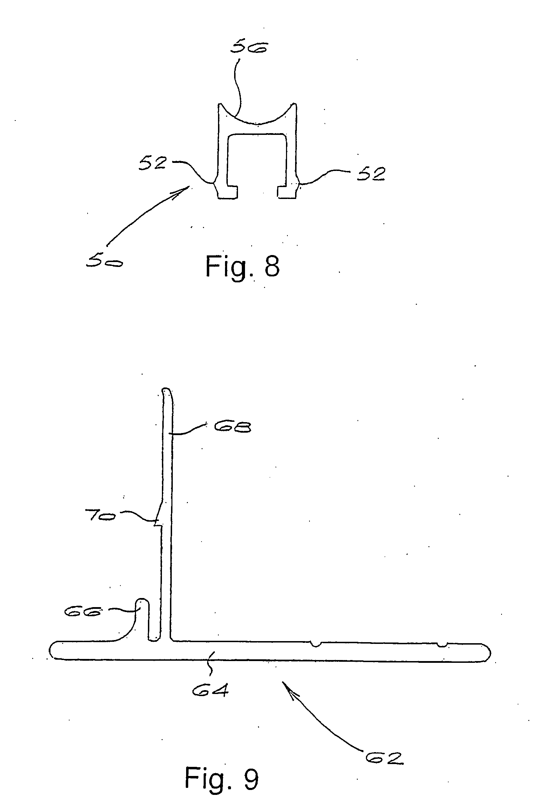

Each component 16 also includes integral, transverse, downwardly projecting receptacles or housings 44 defined by spaced apart elements 46. The receptacles 44 extend for the length of the components and have bases 47 of half-round cross-section. A longitudinally extending conduit 48 of round cross-section is located in each receptacle. As illustrated, the base of each receptacle is complemental in shape to one half of the external surface of a conduit 48. The conduits 48 are held in the receptacles by conduit clips 50, one of which is illustrated at a larger scale in Figure 8. The conduit clips are of extruded aluminium and extend for the full length of the component 16. In practice, with the conduits 48 located in the receptacles, the conduit clips 50 are pressed upwardly between the elements 46 such that laterally projecting lugs 52 on the lugs clip into complemental recesses 54 on the inner surfaces of the legs.

As illustrated, each conduit clip 50 has an upper surface 56 of half round cross-section complemental to the external surface of the conduit 48. Accordingly, with the conduits held in position by the conduit clips, each receptacle and associated conduit clip, in combination, forms a cavity which completely and complementally surrounds the external surface of the conduit for the full length of the component 16. A suitable, thermally conductive gel or elastomer 58 is applied between the external surface of each conduit and the internal surface of the associated cavity to ensure that there is intimate, thermally transmitting contact between the component 16 and the conduit.

In use, the conduits 48, which are made of a material with high thermal conductivity, typically copper, are suitably connected to one another at the ends of the components 16 and are connected to a supply of water, which accordingly flows lengthways relative to the components. The intimate thermally transmitting relationship between the PV cells and the components 16, and between the components 16 and the conduits 48, combined with the high thermal conductivity of the component material, i.e. aluminium and of the adhesive 45 and 58, and the high thermal conductivity of the conduits, ensures that there is efficient heat transfer from the PV cells to the water conveyed by the conduits.

The water accordingly cools the PV cells and enables them to operate efficiently in their electricity producing duty.

As indicated above the hot water which is produced by the apparatus 10 may be taken to a hot water container such as a geyser, or to a swimming pool or other location where hot water is required. The apparatus 10 accordingly serves the dual functions of electricity generation and hot water production.

Referring to Figure 1, the components 16 are located side by side with their formations 20 and 22 in a side by side overlapping relationship the nature of which will be evident from the enlargement in Figure 1. At each junction 60 between adjacent components 16, there is also a connector 62, seen at a larger scale in Figure 9, which has a base 64 and upstanding ribs 66 and 68. The connector is of extruded aluminium and extends for the length of the components. The rib 68 includes a laterally projecting clipping lug 70.The connector is positioned such that the longer rib 68 extends upwardly between opposing surfaces of the formations 20 and 22, with the shorter rib 66 received in a groove 72 in the formation 22 and with the clipping lug 70 making clipping engagement with a laterally extending lug 74 on the formation 22.

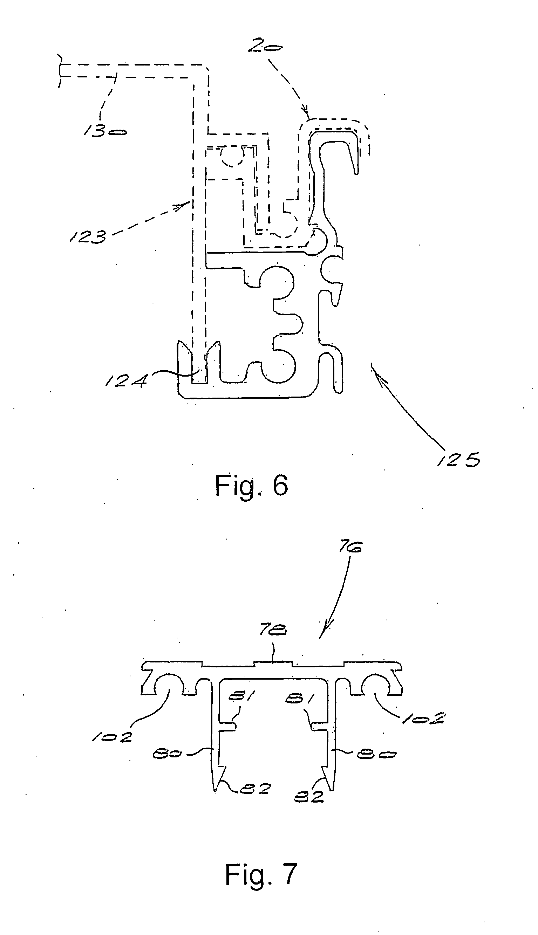

The formations 20 and 22 and the connector 62 are connected to one another at each junction 60 by means of a component clip 76 which is illustrated at a larger scale in Figure 7. The component clip, which is of extruded aluminium and which extends for the length of the components 16, has a top portion 78 and downwardly extending legs 80 which include inwardly directed ribs 81 and arrowhead shape clipping lugs 82. As illustrated in the enlargement in Figure 1, the component clip 76 is driven downwardly relative to the assembly of formations 20 and 22 and connector 62 such that the ribs 80 bear inwardly on overlapping portions of the formations and the clipping lugs 82 make clipping engagement with respective lugs 84 and 86 on the formations 20 and 22. Thus the component clip 76 secures the formations 20 and 22 and the connector 62 to one another, and thereby connects the adjacent components 16 to one another.

The connectors 62 are fastened to the battens 12 by means of screws indicated diagrammatically by the numeral 90. In a typical pitched roof construction battens are provided at a spacing of about 400mm so it will be understood that the interconnected components 16 are fastened to, and supported by, the battens at this regular interval over their length.

Referring again to Figure 1, the apparatus 10 includes, for each component 16, a light transmitting cover 92, in this case made of impact resistant acrylic. The cover 92 has downwardly projecting ribs 94 at positions corresponding to the positions of the undercut channel formations 36. The ribs 94 are of generally U-shaped cross-section. It will be noted that the ribs 94 have an upwardly tapering shape with an external profile complemental to the internal profile of the undercut channel formations 36, enabling the ribs to slide lengthways in the undercut channels.

During assembly, before the component clips 72 are clipped into position, the covers 92 are positioned over the components 16 by sliding the ribs 94 lengthways into the undercut channel formations 36. The covers have a length corresponding to that of the components 16 and so completely cover the components when in position. It will be noted that the covers are positioned some distance above the components 16 and PV cells 42, and that when the covers are in position, downturned side edges 96 thereof locate over edge formations 98 of the formations 20. Sealing strips 100 are positioned in grooves 102 in the component clips 76 to seal against the upper surfaces of the covers when the component clips are installed. Further sealing strips 106 are positioned in grooves 106 in the edge formations 98 of the formations 20 to seal against the lower surfaces of the covers when the component clips are installed. The edges the covers are accordingly sealed top and bottom and are locked relative to the formations 20 and 22 by the component clips 76 when the latter are installed.

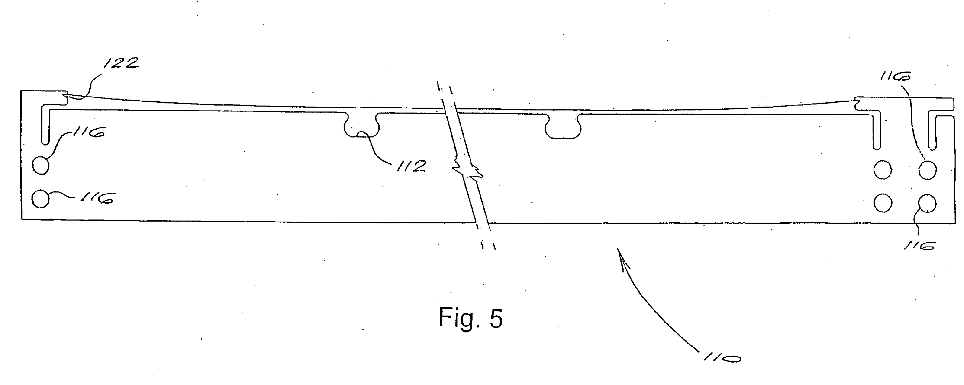

The ends of the apparatus 10 are closed off by end members 110, a typical one of which is seen in Figure 5. The end members, which are in the form of plates of aluminium or other suitable material, span transverse across the ends of the components 10, i.e. in a direction parallel to the battens 12. At each end member, the ends of the ribs 94 of the associated cover 92 locate in cut-outs 112 in the upper edge of the end member, and the end member is secured to the ends of the components 16 by means of screws or other fasteners (not shown) which pass through holes 116 in the end member into screw-receiving openings 118 in the formations 20, 22. A bowed strip of spring steel 120 which spans between grooves 122 at the sides of the end member 110 bear downwardly against the ends of the covers, and thereby reduce the chances of the covers lifting, fluttering or otherwise moving in windy conditions.

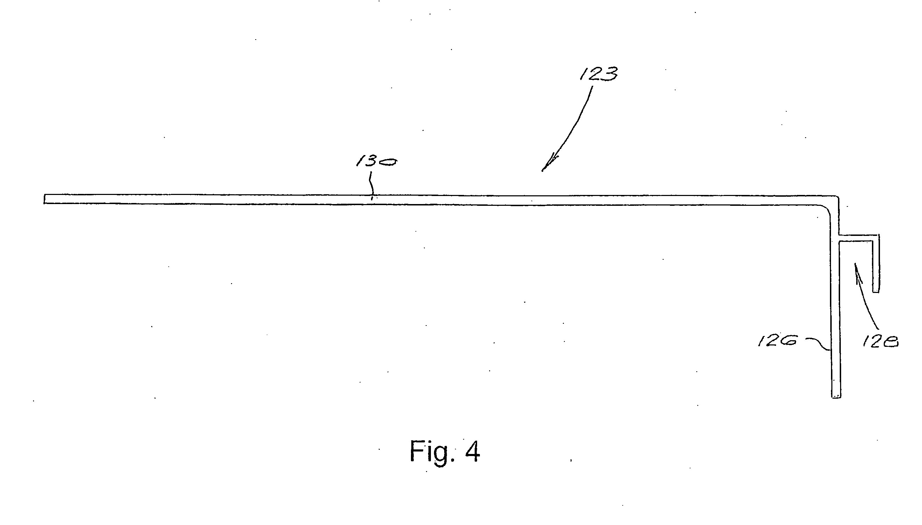

As indicated previously, the illustrated apparatus 10 actually forms part of a roof cladding, i.e. it actually forms part of the roof covering itself. To provide a seal between the apparatus 10 and regions of the remaining roof cladding, for example tiles, sheet metal or the like, lying to the sides of the apparatus, flashings 123 such as that seen in Figure 4 and edge formations 125 such as that seen in Figure 6 are provided. The flashings 123 and edge formations 125 are in the form of aluminium extrusions and extend for the length of the components 16.

Referring to Figure 6, it will be noted that the edge formation 122 has a shape generally corresponding to that of a formation 22, with the addition of an upwardly facing channel 124. As shown in Figure 4, the flashing has a downwardly extending main rib 126 and includes a downwardly facing channel 128. During assembly, and before installation of the component clip at a side edge of the apparatus 10, the edge formation 122 is located alongside the formation 20 which is at the side of the apparatus, the channel 128 of the flashing is positioned in a manner similar to the downturned side 96 of a cover, whereafter the component clip is applied to lock the edge components and flashing together, with a laterally extending portion 130 of the flashing extending some distance over the neighbouring roof cladding. The assembly of flashing and edge formation 122 is indicated in broken outline in Figure 6.

It will be understood that a corresponding assembly is provided at the other side edge of the apparatus 10 to mount a corresponding flashing over the neighbouring roof cladding on that side. In this case, the edge formation provided at the edge of the apparatus will have a shape corresponding to that of a formation 20.

In the final assembly, the apparatus 10 sits flush with neighbouring regions of the roof cladding and forms a part of the cladding between those regions.

Figure 1 shows a single, complete component 10 and portions of adjacent components 10. In practice, there may be many such components making up the full width of the apparatus 10, the number of components being dependent on the amount electricity which is it required to generate and the amount of hot water which it is desired to produce.

The apparatus 10 described above and illustrated in the drawings achieves the desired object of providing efficient cooling of the PV cells. This object is attained by means of a heat-transmitting support structure which supports both the PV cells and conduits and which conveys cooling water, and in which the PV cells and conduits are in intimate heating transmitting relationship with the support structure. The apparatus 10 provides the added advantage of providing heated water for other desired purposes.

The described apparatus 10 has the further advantage that the covers 96 provide the PV cells with protection against impacts, thereby reducing the chances of possible cell breakage. However, the apparatus also solves another problem described at the outset, namely that of having to replace entire PV modules or panels in the event of breakage of a single cell or small group of cells. In the present case, as described above, the components 16, each of which supports a part of the overall PV cell array, are releasably connected to one another and so are individually replaceable. Referring to the enlargement in Figure 1, it is possible to unclip the component clip 76 by inserting a suitable tool into one of the illustrated apertures 140 and manipulating the tool to prise the respective clipping formations apart from one another. Once the component clip 76 has been unclipped it can be removed, whereafter the covers and individual components 16 can be detached from one another and from the connectors 62. This allows a component 16 which supports one or more broken or damaged PV cells to be replaced individually while the remainder of the apparatus 10 is left intact. In other words, it is not necessary to replace the entire panel or array or PV cells. It will be understood that where replacement of a single component 16 is undertaken it will be necessary to disconnect and reconnect the associated water-conveying conduits and electrical connections as required.

Apart from the protection provided by the covers 96, the support structure 14 is itself extremely rigid. This is attributable to the design of the components 16 and in particular the fact that each component includes a number of integrally formed, transverse formations including the formations 20 and 22, the ribs 34, the formations 36 and the receptacles 44. These transverse formations considerably increase the resistance of the components 16 to bending under applied loads, for example the load imposed by a person walking on the apparatus. The bending resistance is of course aided by the fact that the components are themselves supported at small, regular intervals by the battens of the roof support structure. These features also contribute to achieving the objective of reducing possible breakage of or damage to the brittle PV cells.

Referring again to Figure 1, the numeral 150 indicates a bulk insulating material, for example polystyrene or other suitable material, which is located between the receptacles 44 and formations 20, 22, i.e. beneath the recesses 38 and 40. This insulation reduces downward loss of heat generated by the PV cells.

Although the apparatus described above is designed for incorporation as part of a roof cladding structure, it will be understood that it would be quite possible to use the system in a retro-fit application in which it is mounted on an existing, complete roof cladding structure. In this case, the connectors 62 may be modified as necessary, or other mounting arrangements may be provided, to allow the assembled apparatus to be mounted on the existing roof cladding structure.

Also, although the components 16 are in this embodiment provided with three recesses 38, 40, and hence are suitable for accommodating three rows of PV cells, it will be understood that it would be possible in other embodiments for the corresponding components to have only one or recesses, thereby allowing the component to accommodate only one or two row of PV cells, or for the components to have more than three recesses, thereby allowing the component to accommodate more than three separate rows of PV cells.

In situations where only a water heating function is required, as opposed to the dual function of electricity production and water heating, it is possible to replace the PV cells with conventional solar energy absorbers in the recesses 38 and 40. As in the embodiment described above, heat produced by the absorbers is transferred to water in the conduits 48 via the interchangeable support structure components 16 and conduits which will, again, be of thermally conductive material such as copper.

The covers 92 are spaced above the recesses in the components 16, i.e. above the PV cells and accordingly form sealed air spaces above the PV cells while at the same time physically protecting the cells.

## Claims

1. A solar energy collection apparatus (10) comprising a rigid support structure (14) which includes rigid support components (16) made of thermally conductive material connected releasably to one another and carrying operatively downwardly projecting conduit-receiving receptacles (44), PV cells (42) or solar energy absorbers mounted on the components of the support structure in heat transmitting relationship with the components, thermally conductive conduits (48) which are connected to the components of the support structure in heat transmitting relationship with the components and which are arranged to convey water to remove heat from the PV cells or solar energy absorbers via the components and conduits, bulk thermal insulation (150) located beneath recesses (38,40) of the components in which the PV cells (42) or solar energy absorbers are accommodated in order to reduce downward loss of heat generated by the PV cells or solar energy absorbers, and at least one removable, light-transmitting cover (92) spaced above and extending over the cells or solar energy absorbers, **characterised in that**:
the rigid support structure is configured to be connected to a roof support structure (12) such that the apparatus (10) forms part of a roof cladding structure;
the apparatus includes thermally conductive conduit clips (50) which are clipped into the receptacles (44) to anchor the conduits (48) in the receptacles, and
each receptacle and associated clip, in combination, defines a conduit-receiving cavity which is complemental in shape to the external surface of a conduit.

2. A solar energy collection apparatus according to claim 1 wherein the rigid support structure (14) comprises a plurality of elongate, extruded components (16) of thermally conductive material which are connected releasably to one another, each component defining at least one elongate recess (38, 40) in which a row of cells (42) or solar energy absorbers is/are fixed in heat transmitting relationship with the component.

3. A solar energy collection apparatus according to claim 2 wherein the apparatus includes releasable component clips (76) to connect the components (16) of the rigid support structure (14) to one another.

4. A solar energy collection apparatus according to claim 3 wherein the components (16) of the rigid support structure (14) include integral, transverse formations (20, 22) along long edges of the components, the formations of adjacent components lying alongside one another with the component clips (76) serving to connect the formations releasably to one another.

5. A solar energy collection apparatus according to claim 4 wherein each cover (92) has side edges (96) which are connected releasably to the transverse formations (20. 22) by the component clips (76).

6. A solar energy collection apparatus according to claim 5 and comprising seals (106, 100) between the side edges (96) of each cover (92) and the transverse formations (20, 22) and between the side edges of each cover and the component clips (76).

7. A solar energy collection apparatus according to either one of claims 5 or 6 wherein the components (16) of the rigid support structure (14) include further integral, transversely projecting formations (36) extending longitudinally and defining undercut channels, and each cover (92) includes integral, transverse ribs (94) which are received in sliding manner in the undercut channels.

8. A solar energy collection apparatus according to claim 7 wherein the formations (36) defining the undercut channels project upwardly relative to the support structure (14).

9. A solar energy collection apparatus according to any one of the preceding claims wherein the receptacles (44) and conduit clips (50) extend for the full length of the rigid support components (16).

10. A solar energy collection apparatus according to claim 8 or claim 9 and comprising a thermally conductive elastomer(58) between the external surface of each conduit (48) and the internal surface of the cavity in which the conduit is received.

11. A solar energy collection apparatus according to any one of claims 4 to 10 and comprising connectors (62) which are connectable to battens (12) of the roof support structure and are connected releasably to the transverse formations (20, 22) of the components (16).

12. A solar energy collection apparatus according to claim 11 wherein the connectors (62) are connected releasably to the transverse formations (20, 22) of the components by the component clips (76).

13. A solar energy collection apparatus according to claim 11 or claim 12 and comprising extruded edge members (125) which are connected releasably to components (20, 22) at opposite sides of the rigid support structure by component clips and to which can be attached flashing members (123) for overlapping neighbouring regions of the roof cladding structure on opposite sides of the apparatus (10).

14. A solar energy collection apparatus according to any one of claims 11 to 13 and comprising end members (110) connected to ends of the components (16) in order to provide the apparatus (10) with closed ends.

15. A solar energy collection apparatus according to any one of claims 2 to 14 wherein each recess (38, 40) has a width corresponding to that of a single PV cell (42), each recess accommodating a row of single PV cells with a thermally conductive elastomer (45) between the PV cells and a base of the recess.

## Patentansprüche

1. Solarenergie-Sammelvorrichtung (10), umfassend eine biegesteife Trägerkonstruktion (14), die aus wärmeleitenden Material hergestellte biegesteife Trägerbauteile (16) umfasst, die lösbar miteinander verbunden sind und funktionsbereit nach unten vorstehende rohrleitungshaltende Aufnahmeelemente (44) tragen, PV-Zellen (42) oder Solarenergieabsorber, die auf den Bauteilen der Trägerkonstruktion in Wärmeübertragungsbeziehung mit den Bauteilen angebracht sind, wärmeleitende Rohrleitungen (48), die mit den Bauteilen der Trägerkonstruktion in Wärmeübertragungsbeziehung mit den Bauteilen verbunden sind und die angeordnet sind, um zur Entfernung von Wärme von den PV-Zellen oder Solarenergieabsorbern mittels der Bauteile und Rohrleitungen Wasser zu fördern, Volumenwärmedämmung (150), die unterhalb von Aussparungen (38, 40) der Bauteile angeordnet ist, in denen die PV-Zellen (42) oder Solarenergie-absorber aufgenommen sind, um nach unten gerichteten Verlust von Wärme zu verringern, die durch die PV-Zellen oder Solarenergieabsorber erzeugt ist, und mindestens eine entfernbare lichtdurchlässige Abdeckung (92), die über den Zellen oder Solarenergieabsorbern räumlich angeordnet ist und sich darüber erstreckt, **dadurch gekennzeichnet, dass**:
die biegesteife Trägerkonstruktion ausgeführt ist, um mit einer Dachträgerkonstruktion (12) verbunden zu werden, so dass die Vorrichtung (10) Teil einer Dachhautkonstruktion bildet;
die Vorrichtung wärmeleitende Rohrklemmen (50) umfasst, die in die Aufnahmeelemente (44) eingeklemmt sind, um die Rohrleitungen (48) in den Aufnahmeelementen zu befestigen, und
jedes Aufnahmeelement und zugehörige Klemme zusammen einen rohrleitungshaltenden Hohlraum begrenzen, der in der Form zur Außenoberfläche einer Rohrleitung komplementär ist.

2. Solarenergie-Sammelvorrichtung nach Anspruch 1, bei der die biegesteife Trägerkonstruktion (14) eine Mehrzahl von langgestreckten extrudierten Bauteilen (16) aus wärmeleitendem Material umfasst, die lösbar miteinander verbunden sind, wobei jedes Bauteil mindestens eine langgestreckte Aussparung (38, 40) begrenzt, in der eine Reihe von Zellen (42) oder Solarenergieabsorber in Wärmeübertragungsbeziehung mit dem Bauteil befestigt ist/sind.

3. Solarenergie-Sammelvorrichtung nach Anspruch 2, wobei die Vorrichtung lösbare Bauteilklemmen (76) umfasst, um die Bauteile (16) der biegesteifen Trägerkonstruktion (14) miteinander zu verbinden.

4. Solarenergie-Sammelvorrichtung nach Anspruch 3, bei der die Bauteile (16) der biegesteifen Trägerkonstruktion (14) als Einheit ausgeführte querverlaufende Ausbildungen (20, 22) entlang langer Ränder der Bauteile umfassen, wobei die Ausbildungen von benachbarten Bauteilen neben einander liegen, wobei die Bauteilklemmen (76) dazu dienen, um die Ausbildungen lösbar miteinander zu verbinden.

5. Solarenergie-Sammelvorrichtung nach Anspruch 4, bei der jede Abdeckung (92) Seitenränder (96) aufweist, die durch die Bauteilklemmen (76) lösbar mit den querverlaufenden Ausbildungen (20, 22) verbunden sind.

6. Solarenergie-Sammelvorrichtung nach Anspruch 5 und umfassend Dichtungen (106, 100) zwischen den Seitenrändern (96) jeder Abdeckung (92) und den querverlaufenden Ausbildungen (20, 22) und zwischen den Seitenrändern jeder Abdeckung und den Bauteilklemmen (76).

7. Solarenergie-Sammelvorrichtung nach einem der Ansprüche 5 oder 6, bei der die Bauteile (16) der biegesteifen Trägerkonstruktion (14) weiter als Einheit ausgeführte quer vorstehende Ausbildungen (36) umfassen, die sich in Längsrichtung erstrecken und Kanäle mit Unterschnitt begrenzen, und jede Abdeckung (92) als Einheit ausgeführte Querrippen (94) umfasst, die auf verschiebbare Weise in den Kanälen mit Unterschnitt gehalten werden.

8. Solarenergie-Sammelvorrichtung nach Anspruch 7, bei der die die Kanäle mit Unterschnitt begrenzenden Ausbildungen (36) in Bezug zur Trägerkonstruktion (14) nach oben vorstehen.

9. Solarenergie-Sammelvorrichtung nach einem der vorangehenden Ansprüche, bei der sich die Aufnahmeelemente (44) und Rohrklemmen (50) die volle Länge der biegesteifen Trägerbauteile (16) lang erstrecken.

10. Solarenergie-Sammelvorrichtung nach Anspruch 8 oder Anspruch 9 und umfassend ein wärmeleitendes Elastomer (58) zwischen der Außenoberfläche jeder Rohrleitung (48) und der Innenoberfläche des Hohlraums, in dem die Rohrleitung gehalten wird.

11. Solarenergie-Sammelvorrichtung nach einem der Ansprüche 4 bis 10 und umfassend Verbinder (62), die sich mit Dachlatten (12) der Dachträger-konstruktion verbinden lassen und lösbar mit den querverlaufenden Ausbildungen (20, 22) der Bauteile (16) verbunden sind.

12. Solarenergie-Sammelvorrichtung nach Anspruch 11, bei der die Verbinder (62) durch die Bauteilklemmen (76) lösbar mit den querverlaufenden Ausbildungen (20, 22) der Bauteile verbunden sind.

13. Solarenergie-Sammelvorrichtung nach Anspruch 11 oder Anspruch 12 und umfassend extrudierte Randelemente (125), welche an entgegengesetzten Seiten der biegesteifen Trägerkonstruktion durch Bauteilklemmen lösbar mit Bauteilen (20, 22) verbunden sind und an welche Abdeckelemente (123) angebracht werden können, um Nachbargebiete der Dachhautkonstruktion auf entgegengesetzten Seiten der Vorrichtung (10) zu überlagern.

14. Solarenergie-Sammelvorrichtung nach einem der Ansprüche 11 bis 13 und umfassend Endelemente (110), die mit Enden der Bauteile (16) verbunden sind, um die Vorrichtung (10) mit geschlossenen Enden zu versehen.

15. Solarenergie-Sammelvorrichtung nach einem der Ansprüche 2 bis 14, bei der jede Aussparung (38, 40) eine Breite aufweist, die derjenigen einer einzelnen PV-Zelle (42) entspricht, wobei jede Aussparung eine Reihe von einzelnen PV-Zellen mit einem wärmeleitenden Elastomer (45) zwischen den PV-Zellen und einer Basis der Aussparung aufnimmt.

## Revendications

1. Appareil de captage de l'énergie solaire (10) comprenant une structure de support rigide (14) qui inclut des composants de support rigide (16) fabriqués en un matériau conducteur thermiquement, raccordés de manière détachable les uns aux autres et qui portent de manière opérationnelle des réceptacles de réception de conduits faisant saillie vers le bas (44), des cellules PV (42) ou des dispositifs d'absorption de l'énergie solaire montés sur les composants de la structure de support suivant une relation de transmission de chaleur aux composants, des conduits conducteurs thermiquement (48) qui sont raccordés aux composants de la structure de support suivant une relation de transmission de chaleur aux composants et qui sont agencés de manière à acheminer de l'eau pour ôter de la chaleur des cellules PV ou des dispositifs d'absorption de l'énergie solaire par l'intermédiaire des composants et des conduits, une isolation thermique massive (150) située sous les renfoncements (38, 40) des composants dans lesquels sont logés les cellules PV (42) ou les dispositifs d'absorption de l'énergie solaire, afin de diminuer une perte de la chaleur générée par les cellules PV ou par les dispositifs d'absorption de l'énergie solaire, et au moins un capot détachable laissant passer la lumière (92) et espacé vers le haut et s'étendant au-dessus des cellules ou des dispositifs d'absorption de l'énergie solaire ;
**caractérisé en ce que** :
la structure de support rigide est configurée de manière à être raccordée à une structure de support de toit (12) de telle sorte que l'appareil (10) fasse partie d'une structure de revêtement de toit ;
l'appareil incluant des attaches de conduits conductrices thermiquement (50) qui sont fixées à l'intérieur des réceptacles (44) pour ancrer les conduits (48) dans les réceptacles ; et
chaque réceptacle et chaque attache associée définissent, en association, une cavité de réception de conduit qui présente une forme complémentaire de la surface extérieure d'un conduit.

2. Appareil de captage de l'énergie solaire selon la revendication 1, dans lequel la structure de support rigide (14) comprend une pluralité de composants extrudés allongés (16) fabriqués en un matériau conducteur thermiquement, qui sont raccordés de manière détachable les uns aux autres, chaque composant définissant au moins un renfoncement allongé (38, 40) dans lequel est fixée une rangée de cellules (42) ou des dispositifs d'absorption de l'énergie solaire suivant une relation de transmission de la chaleur au composant.

3. Appareil de captage de l'énergie solaire selon la revendication 2, dans lequel l'appareil incluant des attaches de composants détachables (76) destinées à raccorder les composants (16) de la structure de support rigide (14) les uns aux autres.

4. Appareil de captage de l'énergie solaire selon la revendication 3, dans lequel les composants (16) de la structure de support rigide (14) incluent des formations transversales d'une seule pièce (20, 22) le long des bords longs des composants, les formations de composants adjacents se trouvant le long les unes des autres avec les attaches de composants (76), servant à raccorder de manière détachable les formations les unes aux autres.

5. Appareil de captage de l'énergie solaire selon la revendication 4, dans lequel chaque capot (92) présente des bords latéraux (96) qui sont raccordés de manière détachable aux formations transversales (20, 22) par les attaches de composants (76).

6. Appareil de captage de l'énergie solaire selon la revendication 5, comprenant des joints (106, 100) situés entre les bords latéraux (96) de chaque capot (92) et les formations transversales (20, 22) et entre les bords latéraux de chaque capot et les attaches de composants (76).

7. Appareil de captage de l'énergie solaire selon la revendication 5 ou 6, dans lequel les composants (16) de la structure de support rigide (14) incluent d'autres formations d'une seule pièce qui font saillie transversalement (36) s'étendant longitudinalement et définissant des canaux creux, et chaque capot (92) inclut des nervures transversales d'une seule pièce (94) qui sont reçues de manière coulissante dans les canaux creux.

8. Appareil de captage de l'énergie solaire selon la revendication 7, dans lequel les formations (36) définissant les canaux creux font saillie vers le haut par rapport à la structure de support (14).

9. Appareil de captage de l'énergie solaire selon l'une quelconque des revendications précédentes, dans lequel les réceptacles (44) et les attaches de conduits (50) s'étendent sur toute la longueur des composants de support rigide (16).

10. Appareil de captage de l'énergie solaire selon la revendication 8 ou 9, comprenant un élastomère conducteur thermiquement (58) situé entre la surface extérieure de chaque conduit (48) et la surface intérieure de la cavité dans laquelle est reçu le conduit.

11. Appareil de captage de l'énergie solaire selon l'une quelconque des revendications 4 à 10, comprenant des connecteurs (62) qui peuvent être raccordés aux lattes (12) de la structure de support du toit et qui sont raccordés de manière détachable aux formations transversales (20, 22) des composants (16).

12. Appareil de captage de l'énergie solaire selon la revendication 11, dans lequel les connecteurs (62) sont raccordés de manière détachable aux formations transversales (20, 22) des composants par les attaches de composants (76).

13. Appareil de captage de l'énergie solaire selon la revendication 11 ou 12, comprenant des éléments de bord extrudés (125) qui sont raccordés de manière détachable aux composants (20, 22) au niveau des côtés opposés de la structure de support rigide par les attaches de composants, et auxquels peuvent être attachés des éléments de recouvrement (123) destinés à chevaucher des régions voisines de la structure de revêtement de toit sur les côtés opposés de l'appareil (10).

14. Appareil de captage de l'énergie solaire selon l'une quelconque des revendications 11 à 13, comprenant des éléments d'extrémité (110) raccordés aux extrémités des composants (16) afin de fournir à l'appareil (10) des extrémités fermées.

15. Appareil de captage de l'énergie solaire selon l'une quelconque des revendications 2 à 14, dans lequel chaque renfoncement (38, 40) présente une largeur correspondant à celle d'une cellule PV unique (42), chaque renfoncement logeant une rangée de cellules PV uniques, un élastomère conducteur thermiquement (45) se situant entre les cellules PV et une base du renfoncement.
